# EUROPÄISCHE PATENTSCHRIFT

(11) **EP 0 924 029 B1**
(45) Veröffentlichungstag und Bekanntmachung des Hinweises auf die Patenterteilung: **20.03.2002**
(21) Anmeldenummer: 98123050.1
(22) Anmeldetag: 08.12.1998
(51) Int. Cl.: B24B 37/04, H01L 21/304

(54) **Verfahren zum Erzielen eines möglichst linearen Verschleissverhaltens und Werkzeug mit möglichst linearem Verschleissverhalten**
Method to reach an almost linear wear and tool with almost linear wear
Procédé et outil à usure presque linéaire

(30) Priorität: 18.12.1997 DE 19756537
(43) Veröffentlichungstag der Anmeldung: 23.06.1999
(73) Patentinhaber: Wacker Siltronic Gesellschaft für Halbleitermaterialien Aktiengesellschaft, 84489 Burghausen (DE)
(72) Erfinder: Ripper, Bert, 92353 Postbauer-Heng (DE); Hofmann, Robert, 83376 Truchtlaching (DE); Lehfeld, Peter, 84489 Burghausen (DE); Lundt, Holger, Dr., 84489 Burghausen (DE)
(74) Vertreter: Rimböck, Karl-Heinz, Dr.

(56) Entgegenhaltungen:
- WO-A-90/14926
- DE-A- 3 742 953
- US-A- 1 486 341
- US-A- 5 297 364
- US-A- 5 609 718
- US-A- 5 618 447
- US-A- 5 643 405
- PATENT ABSTRACTS OF JAPAN vol. 096, no. 007, 31. Juli 1996 & JP 08 061949 A (SPEEDFAM CO LTD), 8. März 1996

## Beschreibung

Die Erfindung betrifft die materialabtragende Bearbeitung von Halbleiterscheiben. Gegenstand der Erfindung ist ein Verfahren zum Erzielen eines möglichst linearen Verschleißverhaltens bei einem Werkzeug, das eine im wesentlichen ebene Arbeitsfläche zur materialabtragenden Bearbeitung von Halbleiterscheiben besitzt, sowie ein Werkzeug mit einer im wesentlichen ebenen Arbeitsfläche zur materialabtragenden Bearbeitung von Halbleiterscheiben. Gegenstand der Erfindung ist auch ein Verfahren zum Messen eines Verschleißprofils einer im wesentlichen ebenen Arbeitsfläche eines Werkzeugs zum Läppen von Halbleiterscheiben. Gegenstand der Erfindung ist schließlich auch eine Läuferscheibe zum Halten von Halbleiterscheiben zwischen im wesentlichen ebenen Arbeitsflächen eines Werkzeugs zur materialabtragenden Bearbeitung der Halbleiterscheiben, die sich von bekannten Läuferscheiben, wie sie beispielsweise in der US-1,486,341, der eine Läuferscheibe gemäß dem Oberbegriff des Anspruchs 6 offenbart, oder der US 4,739,589 beschrieben sind, vorteilhaft unterscheidet.

Halbleiterscheiben können auf verschiedene Weise einer materialabtragenden Bearbeitung unterzogen werden. Mit der Bearbeitung werden in der Regel eines oder mehrere der folgenden Ziele verfolgt: das Entfernen oberflächennaher Beschädigungen, die Steigerung von Ebenheit und Parallelität der Scheibenseiten und das Glätten der Scheibenseiten. Bei den Bearbeitungswekzeugen handelt es sich üblicherweise um Schleif-, Läpp- und Polierwerkzeuge. Die Werkzeuge besitzen als gemeinsames Merkmal eine im wesentlichen ebene Arbeitsfläche, mit deren Hilfe eine Seite des Werkstückes bearbeitet wird. Während der Bearbeitung des Werkstücks führen das Werkstück und die Arbeitsfläche des Bearbeitungswerkzeuges eine Relativbewegung aus. Man kann im Hinblick auf die Anzahl von Werkstücken, die gleichzeitig bearbeitet werden, zwischen einer Einzelscheiben-Bearbeitung und einer Mehrscheiben-Bearbeitung unterscheiden. Ebenso läßt sich eine Unterscheidung im Hinblick auf die Anzahl der bearbeiteten Scheibenseiten treffen, wobei man zwischen einer Einseiten- und einer Doppelseiten-Bearbeitung unterscheidet. Die vorliegende Erfindung ist grundsätzlich bei allen genannten Bearbeitungsverfahren anwendbar.

Mit der materialabtragenden Bearbeitung eines Werkstücks ist praktisch immer auch ein Verschleiß der Arbeitsfläche des Bearbeitungswerkzeugs verbunden. Mit der Zeit führt dieser Verschleiß dazu, daß eine gleichmäßige Bearbeitung des Werkstücks nicht mehr zu erreichen ist und die Form der bearbeiteten Werkstücke fehlerhaft wird. Die Arbeitsfläche des Werkzeugs muß deshalb in regelmäßigen Abständen abgerichtet, beispielsweise nachgeschliffen oder durch Abrichtringe eingeebnet werden. Häufige Arbeitsunterbrechungen durch Abrichtphasen beeinträchtigen jedoch die Produktivität des Bearbeitungsverfahrens erheblich.

In der WO-90/14926, die der nächstliegende Stand der Technik für die Ansprüche 1 und 3 ist, ist eine Läppmaschine mit besonders ausgebildeten Werkzeugoberflächen beschrieben, die gleichmäßige Verschleißraten zeigen. Die JP-08-061949 A, die ein Verfahren gemäß dem Oberbegriff des Anspruchs 5 offenbart, betrifft eine Messvorrichtung zum Erfassen der Kontur einer Oberfläche, beispielsweise der Oberfläche eines Poliertuchs.

Die vorliegende Erfindung zeigt einen Weg auf, wie das Abrichten der Arbeitsfläche vermieden oder zumindest die zeitlichen Abstände zwischen zwei Abrichtphasen erheblich verlängert werden können.

Gegenstand der Erfindung ist ein Verfahren zum Erzielen eines möglichst linearen Verschleißverhaltens gemäß Anspruch 1.

Gegenstand der Erfindung ist auch ein Werkzeug mit einer im wesentlichen ebenen Arbeitsfläche zur materialabtragenden Bearbeitung von Halbleiterscheiben gemäß Anspruch 3.

Durch die Erfindung läßt sich insbesondere erreichen, daß der unvermeidbare Verschleiß der Arbeitsfläche möglichst gleichmäßig ist und die mit dem Werkstück in Berührung kommende Arbeitsfläche, beispielsweise die Oberfläche einer Läppsscheibe oder eines Poliertuchs, die mit dem Werkstück in Berührung kommt ihre im wesentlichen ebene Form beibehält. Dieses lineare Verschleißverhalten der Arbeitsfläche, das heißt, der über die gesamte Arbeitsfläche des Werkzeugs homogener ausfallende Verschleiß hat zur Folge, daß sich der unvermeidbare Verschleiß der Arbeitsfläche nicht mehr nachteilig auf die Form der bearbeiteten Werkstücke oder die Produktivität des Bearbeitungsverfahrens auswirkt.

Das vorteilhafte Verschleißverhalten der Arbeitsfläche wird erreicht, indem die Arbeitsfläche modifiziert wird und dabei an die tatsächlich vorhandene Verschleißsituation angepaßt wird. Zunächst ist dafür notwendig, das Verschleißprofil der Arbeitsfläche zu ermitteln. Dies geschieht entweder dadurch, daß das Verschleißprofil einer verwendeten Arbeitsfläche gemessen wird, oder dadurch, daß das Verschleißprofil unter Berücksichtigung der während des Bearbeitungsverfahrens vorherrschenden kinematischen Verhältnisse rechnerisch simuliert wird. Die Ergebnisse von Messungen von Verschleißprofilen können auch verwendet werden, um die Modelle, auf denen die Simulationsrechnungen basieren, zu optimieren.

Das ermittelte Verschleißprofil einer Arbeitsfläche ist eine Abbildung der aufgrund von Verschleiß formveränderten Arbeitsfläche, wobei ausschließlich verschleißbedingte Formänderungen der Arbeitsfläche berücksichtigt sind. Deformationen der Arbeitsfläche, die andere Ursachen haben, beipielsweise eine herstellungsbedingte Krümmung der Arbeitsfläche werden nicht mitabgebildet. Bei rotationssymmetrisch beanspruchten Arbeitsflächen, beispielsweise den Schleifscheiben von Schleifwerkzeugen, den Läppscheiben von Läppwerkzeugen und den Poliertüchern von Polierwerkzeugen, gibt bereits ein radiales Verschleißprofil, das entlang eines Radius der Arbeitsfläche ermittelt wird, genaue Auskunft über verschleißbedingte Formveränderungen der Arbeitsfläche.

Die Erfindung sieht vor, die im Verschleißprofil enthaltene Information über die örtlichen Unterschiede im Verschleiß der Arbeitsfläche heranzuziehen und eine modifizierte Arbeitsfläche bereitzustellen. Die modifizierte Arbeitsfläche ist so beschaffen, daß an Orten, die einer stärkeren Beanspruchung ausgesetzt sind, die Widerstandsfähigkeit des Materials der Arbeitsfläche gegen Abrieb erhöht ist, und an Orten, die einer weniger starken Beanspruchung ausgesetzt sind, die Widerstandsfähigkeit des Materials der Arbeitsfläche gegen Abrieb herabgesetzt ist,so daß im Ergebnis eine Vergleichmäßigung des Verschleißverhaltens der modifizierten Arbeitsfläche resultiert. Eine Erhöhung der Widerstandsfähigkeit kann erreicht werden, indem bisher verwendetes Material gehärtet wird oder durch härteres Material ersetzt wird. Eine Verringerung der Widerstandsfähigkeit ergibt sich, indem das bisher verwendete Material durch weicheres Material ersetzt wird oder indem die Grundfläche des Flächenelements, die bei der Bearbeitung von Werkstücken beansprucht wird, verringert wird.

Erfindungsgemäß ist die modifizierte Arbeitsfläche in Flächenelemente unterteilt, die durch bestimmte Eigenschaften charakterisiert sind. Jedes Flächenelement nimmt eine bestimmte Position auf der modifizierten Arbeitsfläche ein und besitzt in der Draufsicht eine bestimmte geometrische Form. Grundsätzlich unterliegt die Form keinen besonderen Einschränkungen. Bevorzugt ist jedoch, daß die Flächenelemente eine Form haben, die aus einer Gruppe ausgewählt ist, die Kreisringe, Kreisringsegmente, Vielecke mit vorzugsweise 3 bis 10 Ekken, Kreisscheiben und Kreisscheibensegmente umfaßt. Die Zahl der Flächenelemente beträgt vozugsweise 3 bis 10 000. Benachbarte Flächenelemente müssen nicht notwendigerweise aneinanderstoßen, sondern können durch einen Spalt mit bestimmter Spaltbreite voneinander getrennt sein. Bei einer Spaltbreite von Null stoßen benachbarte Flächenelemente aneinander. Die Härte des Materials, aus dem ein Flächenelement gefertigt ist, verleiht diesem eine bestimmte Widerstandsfähigkeit gegen Abrieb, die nachfolgend als Verschleißfestigkeit bezeichnet wird. Die Verschleißfestigkeit eines Flächenelements ist demzufolge herabgesetzt, wenn es aus einem weicheren Material besteht, als ein Flächenelement aus härterem Material mit gleicher Form und gleicher Grundfläche. Die Verschleißfestigkeit des Flächenelements ist ebenfalls herabgesetzt, wenn dessen Grundfläche durch die Existenz von Spalten, Bohrungen oder durch andere flächenreduzierende Maßnahmen verkleinert ist. In diesem Fall wird das Flächenelement bei der Bearbeitung von Werkstücken stärker beansprucht, als ein gleichartiges Flächenelement mit größerer Grundfläche.

Zwei Flächenelemente werden als gleichartig betrachtet, wenn sie in ihrer Verschleißfestigkeit übereinstimmen. Zwischen dem ermittelten Verschleißprofil einerseits und der Verschleißfestigkeit und der Position eines Flächenelements auf der modifizierten Arbeitsfläche andererseits besteht ein Zusammenhang. Die Flächenelemente werden entsprechend des erwarteten ortsabhängigen Verschleißes auf der modifizierten Arbeitsfläche positioniert. An Orten auf der Arbeitsfläche, die vergleichbar beansprucht werden, befinden sich auf der modifizierten Arbeitsfläche Flächenelemente gleicher Verschleißfestigkeit. An Orten, die dem ermittelten Verschleißprofil zufolge stärker beansprucht werden, befindet sich ein Flächenelement mit erhöhter Verschleißfestigkeit. Läßt das ermittelte Verschleißprofil eine geringere Beanspruchung an einem Ort erwarten, befindet sich an diesem Ort ein Flächenelement mit verminderter Verschleißfestigkeit. Die modifizierte Arbeitsfläche ist insgesamt so beschaffen, daß der Verschleiß der Flächenelemente trotz örtlich unterschiedlich stark ausgeprägter Beanspruchung möglichst gleichmäßig ist.

Zum Messen eines Verschleißprofils wird das einfach durchzuführende Verfahren gemäß Anspruch 5 vorgeschlagen.

Das Verschleißprofil stimmt mit der tatsächlichen Form der beanspruchten Arbeitsfläche um so besser überein, je größer die Dichte der Meßpunkte ist. Eine exakte Abbildung des Verschleißprofils erhält man, wenn die Arbeitsfläche des Werkzeugs gleichförmig über das Werkstück bewegt wird, und das Werkstück dabei in Ruhe bleibt. Die Oberfläche des Werkstücks wird dabei zum Spiegelbild des Verschleißprofils verändert.

Eine bekannte Vorrichtung zum Messen eines Verschleißprofils umfasst einen Meßkörper mit Stützflächen zum Anlegen des Meßkörpers an die Arbeitsfläche und mindestens einen Sensor, der im Meßkörper untergebracht ist und der den Abstand zwischen einer Referenzfläche und der Arbeitsfläche an einem Meßpunkt der Referenzfläche berührungslos mißt.

Bei der beidseitigen Mehrscheibenbearbeitung kann das Ziel, eine Linearisierung des Verschleißverhaltens der Arbeitsfläche zu erreichen, durch eine besonders ausgeführte Läuferscheibe unterstützt werden.

Gegenstand der Erfindung ist daher auch eine Läuferscheibe gemäß Anspruch 6.

Bei Verwendung dieser Läuferscheiben ist das Verschleißverhalten der Arbeitsflächen gleichmäßiger, als bei Verwendung bisher üblicher Läuferscheiben.

Die Erfindung wird nachfolgend anhand von Figuren weiter erläutert. Soweit die Darstellungen Vorrichtungen zum Bearbeiten von Halbleiterscheiben betreffen, handelt es sich um bevorzugte Ausführungsformen, wobei stellvertretend für alle Anwendungsgebiete der Erfindung Vorrichtungen gezeigt sind, die beim Läppen von Halbleiterscheiben eingesetzt werden können.

In Fig.1 ist eine Vorrichtung entsprechend dem Stand der Technik dargestellt, die sich zum Messen eines Verschleißprofils eignet.

In Fig.2 ist schematisch dargestellt, wie ein Verschleißprofil mit einer Vorrichtung gemäß Fig.1 gemessen wird.

Fig.3 zeigt ein typisches radiales Verschleißprofil einer Läppscheibe.

Die Figuren 4 bis 7 zeigen in Draufsicht die modifizierten Oberflächen von Läppscheiben.

In Fig.8 ist eine Läuferscheibe mit vorteilhaft angeordneten Öffnungen zur Aufnahme von Halbleiterscheiben dargestellt.

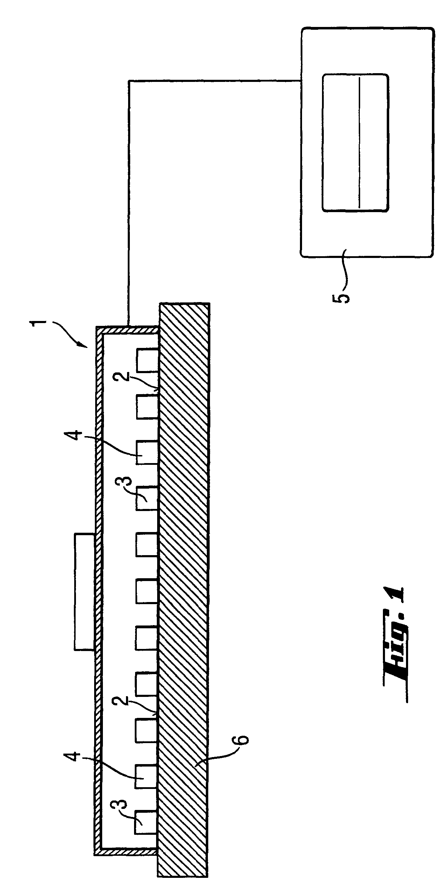

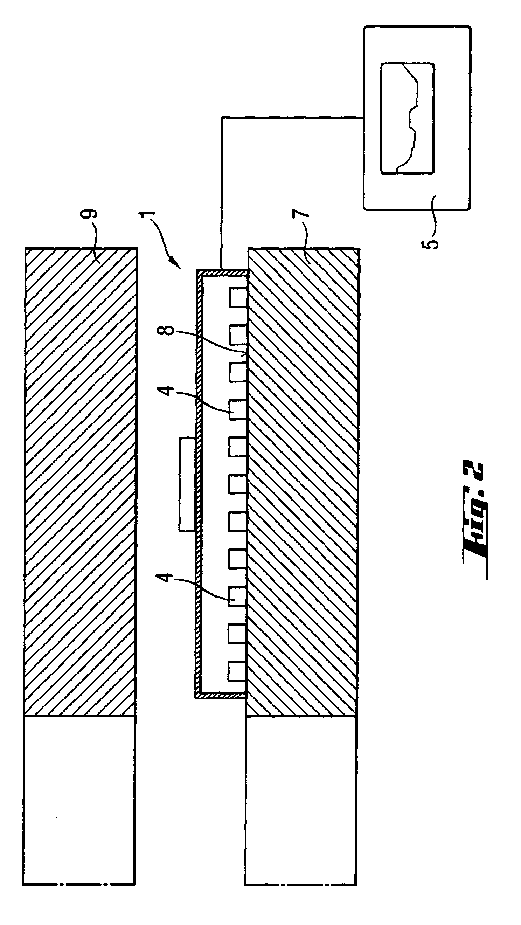

Zur Messung eines Verschleißprofils eignet sich eine Vorrichtung gemäß Fig.1. Die Vorrichtung besteht aus einem Meßkörper 1 mit Stützflächen 2 zum Anlegen des Meßkörpers an eine Arbeitsfläche. Die Stützflächen 2 liegen in einer Ebene. Im Meßkörper ist mindestens ein elektronischer Sensor 3 untergebracht, mit dem berührungslos der Abstand zwischen einer Referenzebene 4 und der Arbeitsfläche gemessen werden kann. Vorzugsweise werden Sensoren eingesetzt, die Abstände nach einem kapazitiven Meßprinzip messen. Die Referenzebene ist deckungsgleich mit der Ebene, in der die Stützflächen liegen, oder sie liegt parallel zu dieser Ebene. Bei der dargestellten Ausführungsform sind mehrere Sensoren in regelmäßigen Abständen feststehend nebeneinander angeordnet. Wenn die Anzahl der Sensoren erhöht wird, kann die Meßgenauigkeit gesteigert werden. Eine hohe Meßgenauigkeit kann allerdings auch mit nur einem Sensor erreicht werden, sofern dieser parallel zur Referenzfläche verfahrbar ist. Der in der Fig.2 gezeigte Meßkörper kann beispielsweise auch statt als Lineal (wie gezeigt) als Schlitten (nicht gezeigt) ausgeführt sein, an dem ein Sensor zur Messung eines Verschleißprofils entlanggeführt wird. Die Vorrichtung ist vorzugsweise an einen Rechner 5 angeschlossen, mit dessen Hilfe das Meßergebnis ausgewertet und visualisiert wird. Die Vorrichtung kann vor einer Messung an ein Vergleichsnormal 6 angelegt und kalibriert werden.

Die Messung eines Verschleißprofils ist in Fig.2 schematisch am Beispiel der Läppscheiben einer Läppmaschine dargestellt. Der Meßkörper 1 ist an die Oberfläche einer unteren Läppscheibe 7 angelegt. Die Abstände zwischen der Referenzfläche 4 und der Oberfläche 8 der unteren Läppscheibe werden entlang des Radius der unteren Läppscheibe an mehreren Meßpunkten der Referenzfläche gemessen und abgespeichert. Bei einer folgenden Messung an der oberen Läppscheibe 9 werden auch die Abstände zwischen der Referenzfläche und der Oberfläche der oberen Läppscheibe entlang des Radius der oberen Läppscheibe an denselben Meßpunkten der Referenzfläche gemessen und abgespeichert. Um zum Verschleißprofil der unteren (oberen) Läppscheibe zu gelangen, wird zunächst der Abstand, der an einem Meßpunkt zwischen diesem Meßpunkt und der Oberfläche der oberen (unteren) Läppscheibe gemessen wurde, vom Abstand subtrahiert, der zwischen diesem Meßpunkt und der Oberfläche der unteren (oberen) Läppscheibe gemessen wurde. Die Differenz wird als Verschleißtiefe bezeichnet und beschreibt den tatsächlichen Verschleiß der entsprechenden Läppscheibe am zugehörigen Meßpunkt. Geometrisch kann die Verschleißtiefe als Vektor verstanden werden, der senkrecht auf der Referenzfläche steht und dessen Länge den Verschleiß der Arbeitsfläche angibt. Das Verschleißprofil einer Arbeitsfläche wird daher vorzugsweise angefertigt, indem die Vektorenden durch Interpolieren miteinander verbunden werden, so daß eine glatte Kurve oder Fläche erhalten wird.

Die Messung des Verschleißprofils einer Arbeitsfläche, die in einer Maschine zur einseitigen Bearbeitung von Werkstücken eingesetzt wird, erfolgt nahezu wie vorstehend beschrieben. Die einem Meßpunkt zuzuordnende Verschleißtiefe erhält man in diesem Fall jedoch aus der Differenz zweier Abstände, die zwischen der Referenzfläche und der Arbeitsfläche an diesem Meßpunkt gemessen wurden, wobei der eine Abstand gemessen wird, bevor ein Verschleiß der Arbeitsfläche eingetreten ist und der andere Abstand gemessen wird, nachdem ein Verschleiß der Arbeitsfläche eingetreten ist.

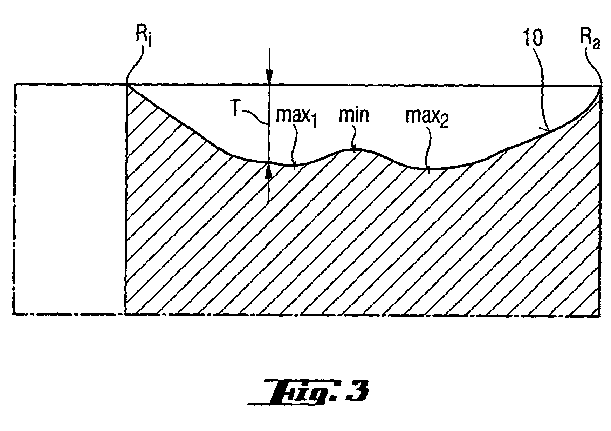

Fig.3 zeigt ein typisches radiales Verschleißprofil einer Läppscheibe. Die Oberfläche 10 der Läppscheibe ist nicht eben, sondern durch unterschiedlich starken Abrieb ungleichmäßig strukturiert. Die Verschleißtiefen T sind zwischen dem Innenrand Rᵢ der Läppscheibe und dem Außenrand Rₐ der Läppscheibe nicht konstant. Sie nehmen zwischen dem Innenrand Rᵢ und einem lokalen Maximum max₁ stetig zu, durchlaufen ein lokales Minimum min zwischen dem lokalen Maximum max₁ und einem lokalen Maximum max₂ und nehmen zwischen dem lokalen Maximum max₂ und dem Außenrand Rₐ wieder stetig ab. Das Verschleißprofil weist eine ungleichmäßige Belastung der Läppscheibe nach, auf die erfindungsgemäß damit reagiert wird, daß die Oberfläche der Läppscheibe modifiziert wird.

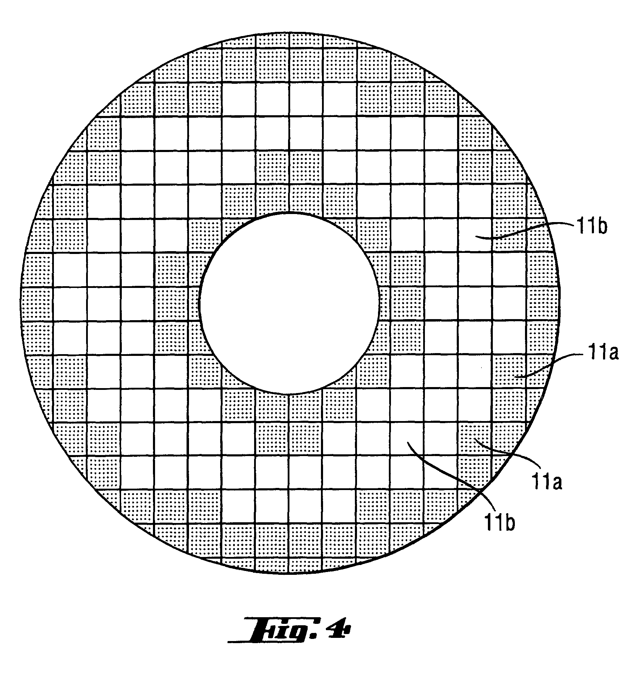

In Figur 4 ist eine Ausführungsform einer Läppscheibe mit modifizierter Oberfläche dargestellt. Die Oberfläche der Läppscheibe ist soweit als möglich in viereckige Flächenelemente 11a und 11b unterteilt. Nicht alle Flächenelemente haben dieselbe Verschleißfestigkeit. Die schraffiert dargestellten Flächenelemente 11a besitzen eine geringere Härte, als die übrigen Flächenelemente 11b. Die Position der härteren Flächenelemente auf der modifizierten Läppscheibe ist so gewählt, daß sie sich an Stellen befinden, an denen einem ermittelten Verschleißprofil zufolge mit einer erhöhten Beanspruchung der Läppscheibenoberfläche zu rechnen ist. Dementsprechend sind die weniger harten Flächenelemente dort positioniert, wo eine geringere Beanspruchung der Läppscheibenoberfläche erwartet wird. Die Härten der Flächenelemente sind so gewählt, daß insgesamt eine Vergleichmäßigung des Verschleißverhaltens der Läppscheibe resultiert. Die Auswahl des geeignetsten Materials für die Flächenelemente erfolgt zweckmäßigerweise anhand von Ergebnissen von Testversuchen.

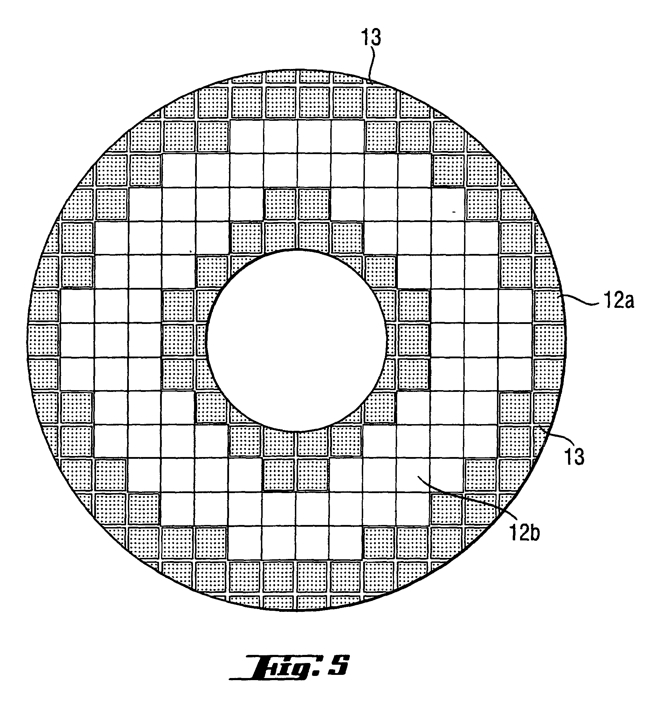

Die in Fig.5 dargestellte, modifizierte Läppscheibenoberfläche ist ebenfalls in viereckige Flächenelemente 12a und 12b mit unterschiedlicher Verschleißfestigkeit unterteilt. Im Unterschied zur Ausführungsform gemäß Fig.4 sind die schraffiert dargestellten Flächenelemente 12a, die eine geringere Verschleißfestigkeit aufweisen, so angeordnet, daß zwischen ihnen ein Spalt 13 mit einer bestimmten Spaltbreite bestehen bleibt. Diese Flächenelemente befinden sich wieder an Stellen der Läppscheibenoberfläche, an denen eine geringere Beanspruchung erwartet wird. Der für die Spalte benötigte Platz wird durch Verringerung der Grundfläche der Flächenelemente geschaffen. Die Verschleißfestigkeit der Flächenelemente ist dadurch weiter vermindert, weil die pro Flächenelement zur Verfügung stehende, beanspruchbare Grundfläche kleiner geworden ist, und die zu erwartende Beanspruchung jedoch unverändert bleibt.

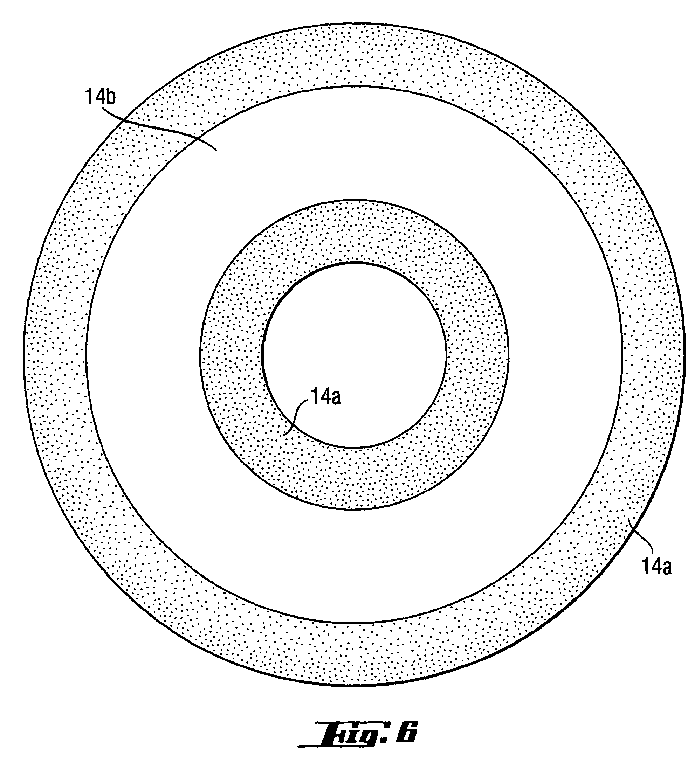

In Fig. 6 ist eine weitere Ausführungsform einer modifizierten Läppscheibenoberfläche dargestellt. Bei dieser Ausführungsform ist die Oberfläche in Flächenelemente 14a und 14b unterteilt, die die Form von konzentrischen Kreisringen haben. Die schraffiert dargestellten Flächenelemente 14a besitzen wiederum eine geringere Verschleißfestigkeit, als die übrigen Flächenelemente 14b. Die Positionen der Flächenelemente sind wiederum so gewählt, daß Flächenelemente mit der geringeren Verschleißfestigkeit in Bereichen angetroffen werden, die einem ermittelten Verschleißprofil zufolge während der Bearbeitung von Werkstücken einer weniger starken Beanspruchung ausgesetzt sein werden und daß Flächenelemente mit der größeren Verschleißfestigkeit Positionen belegen, an denen mit einer erhöhten Beanspruchung zu rechnen ist.

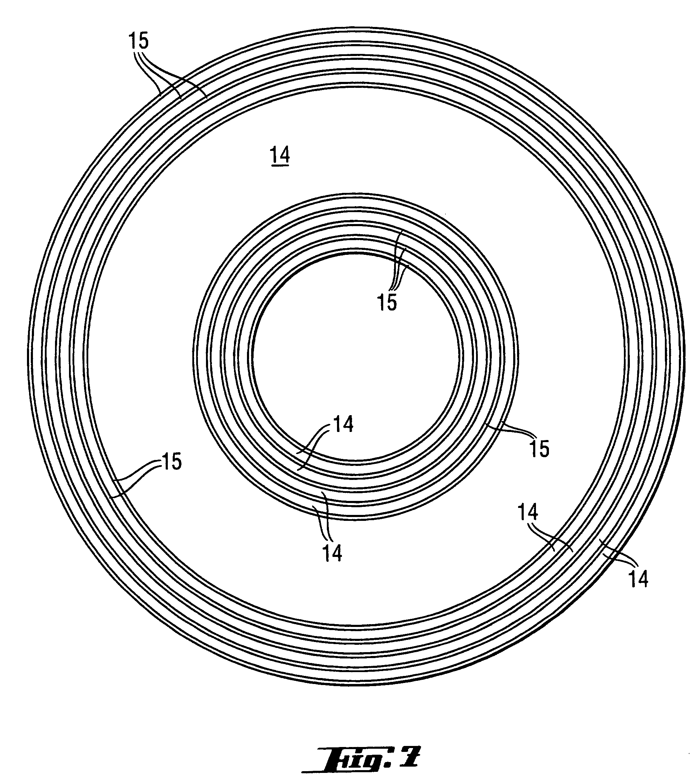

In Fig.7 ist eine weitere Ausführungsform einer modifizierten Läppscheibenoberfläche dargestellt. Die Oberfläche dieser Läppscheibe ist in kreisringförmige Flächenelemente 14 unterteilt. Die Flächenelemente bestehen aus demselben Material und haben keine Härteunterschiede. Dennoch wird durch Spalte 15 zwischen den Flächenelementen erreicht, daß die Verschleißfestigkeit der Läppscheibenoberfläche im Bereich des inneren und des äußeren Randes der Läppscheibe herabgesetzt ist.

Bei der beidseitigen Bearbeitung von Halbleiterscheiben, insbesondere beim Läppen und Polieren von Halbleiterscheiben, haben auch die verwendeten Läuferscheiben einen besonderen Einfluß auf das Verschleißverhalten der Läppscheiben, beziehungsweise Poliertücher.

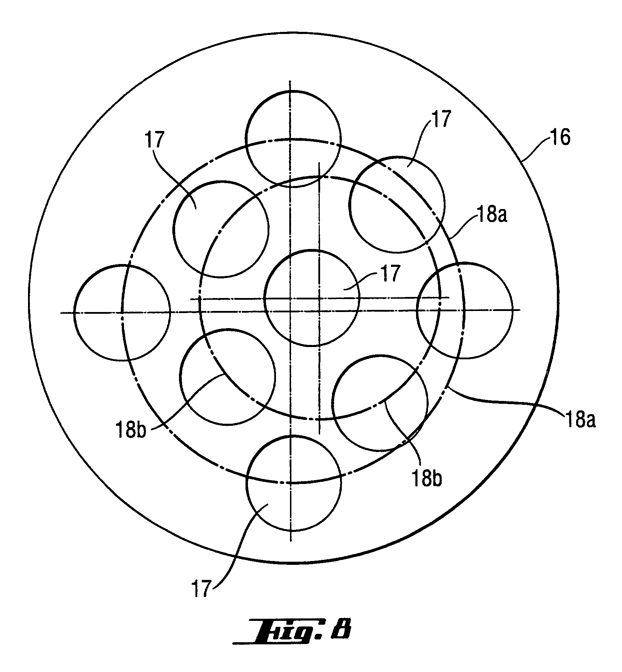

In Figur 8 ist eine besonders bevorzugte Ausführungsform einer Läuferscheibe 16 dargestellt. Die Läuferscheibe zeichnet sich dadurch aus, daß die Werkstückaufnahmen 17 so angeordnet sind, daß unter Berücksichtigung der Kinematik des Bearbeitungsvorganges die Oberflächen der Läppscheiben beziehungsweise Poliertücher möglichst gleichmäßig beansprucht werden. Die Werkstückaufnahmen sind kreisförmige Öffnungen in der Läuferscheibe. Die Mittelpunkte der Öffnungen liegen auf Kreisbahnen 18a und 18b. Gegebenenfalls ist zusätzlich noch eine Öffnung vorhanden, deren Mittelpunkt im Bereich der Mitte der Läuferscheibe liegt. Die auf Kreisbahnen liegenden Mittelpunkte benachbarter Öffnungen liegen auf unterschiedlichen Kreisbahnen. Besonders bevorzugt ist, daß die Kreisbahnen 18a und 18b exzentrisch zueinander liegen.

## Patentansprüche

1. Verfahren zum Erzielen eines möglichst linearen Verschleißverhaltens bei einem Werkzeug, das eine im wesentlichen ebene Arbeitsfläche zur materialabtragenden Bearbeitung von Halbleiterscheiben besitzt, die in Flächenelemente unterteilt ist, von denen jedes eine bestimmte Verschleißfestigkeit aufweist, wobei unterschiedliche Verschleißfestigkeiten auftreten und
ein Verschleißprofil der Arbeitsfläche ohne die Flächenelemente gemessen wird, wobei das gemessene Verschleißprofil zwischen einem Innenrand und einem Außenrand der Arbeitsfläche durch einen radialen Verlauf von Verschleißtiefen T geprägt ist, die zwischen dem Innenrand und einem lokalen Maximum stetig zunehmen, ein lokales Minimum und ein weiteres lokales Maximum durchlaufen und zum Außenrand stetig abnehmen; und
die Arbeitsfläche derart modifiziert wird, daß sie in die Flächenelemente unterteilt ist, wobei ein Flächenelement eine bestimmte Position auf der Arbeitsfläche einnimmt, und jedes Flächenelement derartig auf der Arbeitsfläche angeordnet wird, daß ein Zusammmenhang besteht zwischen dem gemessenen Verschleißprofil einerseits und der Verschleißfestigkeit und der Position des Flächenelementes andererseits.

2. Verfahren nach Anspruch 1, bei dem die Verschleißfestigkeit der Flächenelemente durch flächenreduzierende Maßnahmen herabgesetzt wird.

3. Werkzeug mit einer im wesentlichen ebenen Arbeitsfläche zur materialabtragenden Bearbeitung von Halbleiterscheiben, die in Flächenelemente unterteilt ist, von denen jedes eine bestimmte Verschleißfestigkeit besitzt und eine bestimmte Position auf der Arbeitsfläche einnimmt, und ein Zusammenhang besteht zwischen einem Verschleißprofil einerseits und der Verschleißfestigkeit und der Position des Flächenelementes andererseits, wobei Flächenelemente mit gleicher Verschleißfestigkeit in konzentrischen Bahnen zwischen einem Innenrand und einem Außenrand der Arbeitsfläche entsprechend eines gemessenen Verschleißprofils angeordnet sind, und das Verschleißprofil durch einen radialen Verlauf von Verschleißtiefen T geprägt ist, die zwischen dem Innenrand und einem lokalen Maximum stetig zunehmen, ein lokales Minimum und ein weiteres lokales Maximum durchlaufen und zum Außenrand stetig abnehmen.

4. Werkzeug nach Anspruch 3, bei dem die Flächenelemente in der Draufsicht eine geometrische Form besitzen, die ausgewählt ist aus einer Gruppe, die Kreisringe, Kreisringsegmente, Vielecke mit mindestens drei Ecken, Kreisscheiben und Kreisscheibensegmente umfaßt.

5. Verfahren zum Messen eines Verschleißprofils einer im wesentlichen ebenen Arbeitsfläche eines Werkzeugs zum Läppen von Halbleiterscheiben, wobei die Abstände zwischen einer ebenen Referenzfläche und einer unteren Läppscheibe an mehreren Meßpunkten der Referenzfläche entlang eines Radius der unteren Läppscheibe berührunglos gemessen werden; **dadurch gekennzeichnet, daß**
eine entsprechende Messung der Abstände zwischen den selben Meßpunkten der Referenzfläche und einer oberen Läppscheibe durchgeführt wird;
die gemessenen Abstände durch Differenzbildung der an einem Meßpunkt gewonnenen Abstände in Verschleißtiefen umgerechnet werden; und
anhand der Verschleißtiefen ein Verschleißprofil der Arbeitsfläche angefertigt wird.

6. Läuferscheibe zum Halten von Halbleiterscheiben zwischen im wesentlichen ebenen Arbeitsflächen eines Werkzeuges zur materialabtragenden Bearbeitung der Halbleiterscheiben, mit kreisförmigen Öffnungen zur Aufnahme der Halbleiterscheiben, wobei die Mittelpunkte der Öffnungen auf Kreisbahnen und gegebenenfalls im Bereich der Mitte der Läuferscheibe angeordnet sind und die auf einer Kreisbahn angeordneten Mittelpunkte benachbarter Öffnungen auf verschiedenen Kreisbahnen liegen, **dadurch gekennzeichnet, daß** die Kreisbahnen exzentrisch zueinander liegen.

## Claims

1. Method for achieving a wear performance which is as linear as possible in the case of a tool which has an essentially planar working surface for the material-removing machining of semiconductor wafers, which is divided into surface elements, each of which has a specific wear resistance, with different wear resistances occurring, and
a wear profile of the working surface is measured without the surface elements; the measured wear profile between an inner edge and an outer edge of the working surface being marked by a radial sequence of wear depths T, which increase continuously between the inner edge and a local maximum, pass through a local minimum and a further local maximum and decrease continuously towards the outer edge; and
the working surface is modified in such a way that it is divided into surface elements, a surface element adopting a specific position on the working surface, and each surface element being arranged on the working surface in such a way that there is a relationship between the wear profile measured, on the one hand, and the wear resistance and the position of the surface element, on the other hand.

2. Method according to Claim 1, in which the wear resistance of the surface elements is decreased by measures which reduce the surface area.

3. Tool having an essentially planar working surface for the material-removing machining of semiconductor wafers, which working surface is divided into surface elements, each of which has a specific wear resistance and adopts a specific position on the working surface, and there being a connection between a wear profile, on the one hand, and the wear resistance and the position of the surface element, on the other hand, surface elements of the same wear resistance being arranged in concentric paths between an inner edge and an outer edge of the working surface corresponding to a measured wear profile, and the wear profile being marked by a radial sequence of wear depths T which increase continuously between the inner edge and a local maximum, pass through a local minimum and a further local maximum and decrease continuously towards the outer edge.

4. Tool according to Claim 3, in which the surface elements, in plan view, have a geometric shape which is selected from a group which comprises rings, ring segments, polygons with at least three sides, circles and circle segments.

5. Method for measuring a wear profile of an essentially planar working surface of a tool for the lapping of semiconductor wafers, the distances between a planar reference surface and a lower lapping wheel being measured at a plurality of measurement points on the reference surface along a radius of the lower lapping wheel; **characterized in that**
a corresponding measurement of the distances between the same measurement points on the reference surface and an upper lapping wheel is carried out;
the measured distances are converted into wear depths by forming the difference between the distances obtained at a measurement point; and
a wear profile of the working surface is compiled on the basis of the wear depths.

6. Carrier for holding semiconductor wafers between essentially planar working surfaces of a tool for material-removing machining of the semiconductor wafers, said disc having circular openings for accommodating the semiconductor wafers, the centres of the openings being arranged on circular paths and, if appropriate, in the region of the centre of the carrier, the centres of adjacent openings which are arranged on a circular path lying on different circular paths, **characterized in that** the circular paths are eccentric with respect to one another.

## Revendications

1. Procédé pour l'obtention d'un comportement à l'usure aussi linéaire que possible pour en outil qui possède une surface de travail essentiellement plane pour le traitement d'enlèvement de matière de disques semiconducteurs, laquelle surface est divisée en éléments de surface dont chacun présente une résistance à l'usure définie, différentes résistances à l'usure étant présentes, et
un profil d'usure de la surface de travail sans les éléments de surface est mesuré, le profil d'usure mesuré se manifestant par une évolution radiale de profondeurs d'usure T entre un bord intérieur et un bord extérieur de la surface de travail, lesquelles profondeurs d'usure augmentent de façon constante entre le bord intérieur et un maximum local, passent par un minimum local et un autre maximum local et diminuent de manière constante en direction du bord extérieur ; et
la surface de travail est modifiée de manière être divisée en les éléments de surface, un élément de surface prenant une position définie sur la surface de travail et chaque élément de surface étant disposé sur la surface de travail de telle sorte qu'il existe une dépendance entre le profil d'usure mesuré, d'une part, et la résistance à l'usure et la position de l'élément de surface, d'autre part.

2. Procédé selon la revendication 1, dans lequel la résistance à l'usure des éléments de surface est diminuée par des dispositions de réduction de la surface.

3. Outil comportant une surface de travail essentiellement plane pour le traitement d'enlèvement de matière de disques semiconducteurs, laquelle surface est divisée en éléments de surface dont chacun possède une résistance à l'usure définie et prend une position définie sur la surface de travail, une dépendance existant entre un profil d'usure, d'une part, et la résistance à l'usure et la position de l'élément de surface, d'autre part, des éléments de surface présentant la même résistance à l'usure étant disposés sur des pistes concentriques entre un bord intérieur et un bord extérieur de la surface de travail en correspondance à un profil d'usure mesuré, le profil d'usure se manifestant par une évolution radiale de profondeurs d'usure T qui augmentent de manière constante entre le bord intérieur et un maximum local, passent par un minimum local et un autre maximum local et augmentent de façon constante en direction du bord extérieur.

4. Outil selon la revendication 3, dans lequel, vus en plan, les éléments de surface possèdent une forme géométrique qui est sélectionnée dans un groupe qui comprend les anneaux circulaires, les segments de cercle, les polygones à au moins trois sommets, les disques circulaires et les segments de disque circulaire.

5. Procédé pour la mesure d'un profil d'usure d'une surface de travail essentiellement plane d'un outil de rodage de disques semiconducteurs, les écarts entre une surface de référence plane et un disque inférieur de rodage étant mesurés sans contact en plusieurs points de mesure de la surface de référence situés le long d'un rayon du disque inférieur de rodage, **caractérisé en ce que** l'on réalise une mesure appropriée des écarts entre les mêmes points de mesure de la surface de référence et d'un disque supérieur de rodage,
**en ce que** les écarts mesurés sont convertis par calcul en profondeurs d'usure par soustraction des écarts mesurés en un point de mesure, et
**en ce qu'**un profil d'usure de la surface de travail est déterminé à l'aide des profondeurs d'usure.

6. Disque de meulage pour le maintien de disques semiconducteurs entre des surfaces de travail essentiellement planes d'un outil pour le traitement par enlèvement de matière de disques semiconducteurs, présentant des ouvertures de forme circulaire pour la réception des disques semiconducteurs, les centres des ouvertures étant disposés sur des parcours circulaires et éventuellement dans la région du centre du disque de meulage et les centres d'ouvertures voisines disposées sur un parcours circulaire étant situés sur différents parcours circulaires, **caractérisé en ce que** les parcours circulaires sont disposés excentriquement les uns par rapport aux autres.
